# EUROPÄISCHE PATENTSCHRIFT

(11) **EP 1 916 723 B1**
(45) Veröffentlichungstag und Bekanntmachung des Hinweises auf die Patenterteilung: **02.12.2020**
(21) Anmeldenummer: 07020723.8
(22) Anmeldetag: 23.10.2007
(51) Int. Cl.: H01L 51/50, H01L 27/32, H01L 51/52

(54) **Organische lichtemittierende Diode und Verfahren zur Herstellung einer organischen lichtemittierenden Diode**
Organic light-emitting diode and method for manufacturing an organic light-emitting diode
Diode luminescente organique et procédé de fabrication d'une diode luminescente organique

(30) Priorität: 25.10.2006 DE 102006051101
(43) Veröffentlichungstag der Anmeldung: 30.04.2008
(73) Patentinhaber: OSRAM OLED GmbH, 93055 Regensburg (DE)
(72) Erfinder: Pätzold, Ralph Dr., 91154 Roth (DE); Sarfert, Wiebke, 91074 Herzogenaurach (DE); Klein, Markus Dr., 93105 Tegernheim (DE)
(74) Vertreter: Epping - Hermann - Fischer

(56) Entgegenhaltungen:
- EP-A2- 0 901 176
- JP-A- 2000 173 777
- US-A- 5 949 186
- US-A1- 2004 092 195

## Beschreibung

Die Erfindung betrifft eine OLED mit strukturierter Abstrahlung und ein Herstellungsverfahren für eine OLED mit strukturierter Abstrahlung.

Die Bedeutung von organischen lichtemittierenden Dioden (OLED) und insbesondere die Bedeutung der OLED-Technologie für Displays, Beleuchtungsanwendungen und Beschilderung nimmt stetig zu. Insbesondere auf Grund ihrer einfachen und kostengünstigen Prozessierung sind OLED-Bauelemente dafür prädestiniert, nicht bewegte, d.h. starre, gleich bleibende Symbole und Beschriftungen zur Kennzeichnung, Beschilderung bzw. Visualisierung darzustellen. Die dafür eingesetzten OLEDs kann man schlicht "starre OLEDs" nennen, wobei sich das "starr" auf den gleich bleibenden, in seiner Form unveränderlichen leuchtenden Bereich der Leuchtanzeige und nicht auf elastische Eigenschaften des lichtemittierenden Bauelements selbst bezieht.

Um bei OLEDs die starre Darstellung von Symbolen oder Beschriftungen, also eine strukturierte Abstrahlung, zu ermöglichen, bedarf es einer Strukturierung. Prinzipiell definiert der Überlappungsbereich von Anode und Kathode die leuchtende Fläche der OLED. Mit entsprechender Strukturierung der Elektroden ist es daher möglich, festgelegte Formen, Symbole und Text darzustellen. Stand der Technik ist dabei, die ITO-Anode über photolithographisches Ätzen zu strukturieren und die Kathode während des thermischen Aufdampfens durch den Einsatz von Schattenmasken strukturiert aufzutragen. Insbesondere unter dem Gesichtpunkt einer einfachen und kostengünstigen Prozessierung von OLEDs für einfache Anzeigeelemente, erweist sich die photolithographische Strukturierung als nicht geeignet, da es sich hierbei auf Grund der Vielzahl von Prozessschritten um ein komplexes und auch zeitintensives Verfahren handelt. Zudem erfordert die Photolithographie den Einsatz von Chemikalien, die sowohl bei der Anschaffung als auch Entsorgung Kosten verursachen und tiefer liegende Schichten beschädigen können.

Die Druckschrift US 5,949,186 A offenbart ein organisches elektrolumineszierendes Element mit einer ersten Elektrode aus ITO auf einem Substrat aus Glas und darüber einer organischen Licht emittierenden Schicht. Darüber ist eine strukturierte Elektroneninjektionsschicht aus Bariumoxid, Strontiumoxid, Kalziumoxid oder aus einer Legierung aus Aluminium und Lithium aufgebracht, die in eine zweite Elektrode aus Aluminium eingebettet ist. Weiterhin beschreibt diese Druckschrift ein organisches, elektrolumineszierendes Element mit einer strukturierten Lochblockierschicht, die in eine organische Schicht eingebettet ist, sowie ein organisches elektrolumineszierendes Element, das eine strukturierte Lochinjektionsschicht auf der ersten Elektrode aufweist, die in eine organische Schicht eingebettet ist.

Die Druckschrift US 2004/0092195 A1 beschreibt ein organisches elektrolumineszierendes Bauelement mit einer die Ladungsträgerleitung kontrollierenden Schicht, die in oder auf einer organischen oder leitenden Schicht angeordnet ist und die aus einem Alkylsiloxan ist.

Die Druckschrift JP 2000-173777 A beschreibt ein organisches elektrolumineszierendes Bauelement mit einer strukturierten Löcherblockschicht, die von einer darüber angeordneten Lochtransportschicht bedeckt ist.

Die Druckschrift EP 0 901 176 A2 beschreibt ein organisches elektrolumineszierendes Bauelement mit einem Glassubstrat, auf dem eine in Bereiche strukturierte ITO-Anode angeordnet ist. Die Bereiche sind von einer darüber aufgebrachten leitfähigen Polymerschicht bedeckt, deren Leitfähigkeit so gewählt ist, dass zwar in die über der Polymerschicht angeordnete organische Licht emittierende Schicht Ladungsträger injiziert werden können, aber kein Crosstalk und keine laterale Stromverbreiterung zwischen den Bereichen auftritt.

Aufgabe von zumindest einer Ausführungsform der Erfindung ist es, eine strukturierte Abstrahlung für eine OLED, insbesondere eine starre OLED, zu schaffen. Aufgabe von zumindest einer weiteren Ausführungsform ist, ein Verfahren zur Herstellung einer OLED mit strukturierter Abstrahlung anzugeben.

Diese Aufgaben werden durch einen Gegenstand und ein Verfahren mit den Merkmalen der unabhängigen Patentansprüche gelöst. Vorteilhafte Ausführungsformen und Weiterbildungen des Gegenstands und des Verfahrens sind in den abhängigen Ansprüchen gekennzeichnet und gehen weiterhin aus der nachfolgenden Beschreibung und den Zeichnungen hervor.

Eine organische lichtemittierende Diode (OLED) gemäß einer Ausführungsform umfasst insbesondere
- ein transparentes Substrat und
- auf dem Substrat eine organische lichtemittierende Schicht, die zwischen einer transparenten Elektrode und einer weiteren Elektrode angeordnet ist,
   wobei
- die transparente Elektrode zwei Schichten aufweist und die zwei Schichten eine strukturierte erste Schicht, die eine Ladungsträgerinjektionsschicht ist, und eine leitfähige zweite Schicht, in die die erste Schicht eingebettet ist, umfassen,
- die transparente Elektrode auf der dem Substrat zugewandten Seite der organischen Licht emittierenden Schicht angeordnet ist und
- die strukturierte erste Schicht zwischen der organischen lichtemittierenden Schicht und der leitfähigen zweiten Schicht angeordnet ist und die zweite Schicht im Vergleich zur ersten Schicht eine geringere oder gar keine Ladungsträgerinjektion in die organische lichtemittierende Schicht aufweist

Gemäß einer weiteren Ausführungsform umfasst ein Verfahren zur Herstellung einer organischen lichtemittierenden Diode (OLED) insbesondere die Schritte:
- auf einem transparenten Substrat wird eine organische lichtemittierende Schicht aufgebracht und die organische lichtemittierende Schicht wird zwischen einer transparenten Elektrode und einer weiteren Elektrode angeordnet,
   wobei
- die transparente Elektrode derart aufgebracht wird, dass eine strukturierte erste Schicht, die eine Ladungsträgerinjektionsschicht ist, in eine leitfähige zweite Schicht eingebettet wird,
   wobei
- die transparente Elektrode auf der dem Substrat zugewandten Seite der organischen Licht emittierenden Schicht angeordnet ist und die strukturierte erste Schicht zwischen der organischen lichtemittierenden Schicht und der leitfähigen zweiten Schicht angeordnet ist und die zweite Schicht im Vergleich zur ersten Schicht eine geringere oder gar keine Ladungsträgerinjektion in die organische lichtemittierende Schicht aufweist.

Dabei können die organische lichtemittierende Schicht, die transparente Elektrode und die weitere Elektrode großflächig aufgebracht werden, so dass die organische lichtemittierende Schicht, die transparente Elektrode und die weitere Elektrode großflächig auf dem Substrat aufgebracht sind.

Weiterhin kann "großflächig" hier und im Folgenden bedeuten, dass die organische lichtemittierende Schicht und/oder die Elektroden kontinuierlich und zusammenhängend auf das Substrat aufgebracht sind.

Dabei kann "strukturiert" hier und im Folgenden bedeuten, dass eine Schicht entlang einer Erstreckungsrichtung oder einer Erstreckungsebene der OLED strukturiert ist. Die Erstreckungsrichtung und/oder die Erstreckungsebene, wobei letztere durch zwei Erstreckungsrichtungen definiert sein kann, kann dabei beispielsweise parallel zur einer Hauptoberfläche des Substrats sein, auf der die organische lichtemittierende Schicht und die Elektroden aufgebracht sind. Das kann bedeuten, dass die Erstreckungsrichtung bzw. die Erstreckungsebene senkrecht zur Aufbring- und Abfolgerichtung der Elektroden und der organischen lichtemittierenden Schicht ist.

Weiterhin kann "eingebettet" bedeuten, dass die erste Schicht zumindest teilweise von der zweiten Schicht umschlossen ist.

Für eine derartige OLED kann es möglich sein, die Elektroden und die organische lichtemittierende Schicht durchgehend und großflächig übereinander anzuordnen und dennoch eine strukturierte Abstrahlung zu ermöglichen. Durch eine strukturierte Abstrahlung kann im Betrieb der OLED für einen Betrachter ein strukturierter Leuchteindruck entstehen. Eine strukturierte Abstrahlung bzw. ein strukturierter Leuchteindruck kann beispielsweise eine Information in Form eines Bildes, eines Piktogramms oder eines Zeichens an einen Betrachter vermitteln. Dabei kann beispielsweise in einer Positivdarstellung OLED in den Bereichen, die die informationstragende Form bilden, Licht abstrahlen. Alternativ können in einer Negativdarstellung Bereiche der OLED, die die informationstragende Form umgeben, Licht abstrahlen. Die eingangs erwähnte aufwändige photolithographische Strukturierung kann dabei entfallen, da es möglich sein kann, dass von keinen Bereichen des Substrats nach dem Aufbringen der Elektroden und/oder der organischen lichtemittierenden Schicht Teile oder Bereiche einer Elektrode und/oder Teile oder Bereiche der organischen lichtemittierenden Schicht wieder entfernt werden müssen.

Die strukturierte Abstrahlung ist durch eine strukturierte Ladungsträgerinjektion der strukturierten ersten Schicht in die organische lichtemittierende Schicht möglich. Das Material der zweiten Schicht weist dazu eine schlechtere, d.h. im Vergleich zur ersten Schicht geringere oder gar keine Ladungsträgerinjektion in die organische lichtemittierende Schicht auf. Die zweite Schicht kann dabei eine elektrische Kontaktierung der strukturierten ersten Schicht gewährleisten, das bedeutet, dass der elektrische Widerstand zwischen der ersten Schicht und der zweiten Schicht zumindest näherungsweise die Charakteristik eines ohmschen Widerstands aufweist.

Die erste Schicht kann dabei räumlich strukturiert sein, etwa in räumlich voneinander getrennten Bereichen, wohingegen die Elektrode, die die erste Schicht aufweist, großflächig und kontinuierlich ausgebildet sein kann.

Dabei kann die organische lichtemittierende Schicht eine Schichtenstapel umfassen, der eine oder mehrere der folgenden Schichten aufweisen kann, die aufeinander angeordnet sein können: eine Lochinjektionsschicht, eine Lochtransportschicht, eine Elektronensperrschicht, eine Elektrolumineszenzschicht, eine Lochsperrschicht, eine Elektronentransportschicht und eine Elektroneninjektionsschicht. Diese Schichten können insbesondere großflächig aufgebracht sein. Eine der transparenten Elektrode und der weiteren Elektrode kann dabei geeignet sein, Elektronen in die organische lichtemittierende Schicht zu injizieren, während die andere der transparenten Elektrode und der weiteren Elektrode geeignet sein kann, Löcher zu injizieren. Die Elektronen und Löcher können dann in einem aktiven Bereich der organischen lichtemittierenden Schicht unter Abstrahlung von Licht rekombinieren. Der aktive Bereich kann dabei von einer Grenzfläche zwischen einer Lochtransportschicht und einer Elektronentransportschicht oder durch eine Elektrolumineszenzschicht gebildet werden.

Hier und im Folgenden bedeutet "Licht" elektromagnetische Strahlung aus einem ultravioletten bis infraroten Wellenlängenbereich. Insbesondere kann das abgestrahlte Licht einen sichtbaren Wellenlängenbereich umfassen.

Dass eine Schicht oder ein Element "auf" oder einer anderen Schicht oder einem anderen Element angeordnet oder aufgebracht ist, kann dabei hier und im Folgenden bedeuten, dass die eine Schicht oder das eine Element unmittelbar im direkten mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht angeordnet sein. Beispielsweise kann das Substrat Glas, Quarz, Kunststofffolien, Metall, Metallfolien, Siliziumwafer oder ein anderes geeignetes Substratmaterial umfassen oder aus einem solchen sein. Gemäß der Erfindung ist die OLED als so genannter "Bottom-Emitter" ausgeführt, das heißt, dass das in der organischen lichtemittierenden Schicht erzeugte Licht durch das Substrat abgestrahlt wird, und das Substrat weist eine Transparenz für zumindest einen Teil des abgestrahlten Lichts auf.

Gemäß der Erfindung ist die transparente Elektrode auf der dem Substrat zugewandten Seite der organischen lichtemittierenden Schicht angeordnet. Die transparente Elektrode kann dabei als Anode ausgeführt sein und kann somit als Löcher-injizierendes Material dienen. Sie kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, die beispielsweise Zinkoxid, Zinnoxid, Cadmiumoxid, Titanoxid, Indiumoxid oder Indiumzinnoxid (ITO) aufweisen. Neben binären Metallsauerstoffverbindungen wie beispielsweise ZnO, SnO₂ oder In₂O₃ gehören auch ternäre Metallsauerstoffverbindungen wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Alternativ oder zusätzlich kann die transparente Elektrode auch zumindest eine transparente Metallschicht aufweisen. Eine Metallschicht kann transparent sein, wenn ihre Dicke beispielsweise kleiner oder gleich 100 nm beträgt, bevorzugt kleiner oder gleich 50 nm oder kleiner oder gleich 20nm.

Die weitere Elektrode kann dabei als Kathode ausgebildet sein und somit als Elektronen-injizierendes Material dienen. Zusätzlich kann die weitere Elektrode auch transparent ausgeführt sein. Auch können die transparente Elektrode als Kathode und die weitere Elektrode als Anode ausgeführt sein.

Gegenstand zumindest einer weiteren Ausführungsform ist eine organische lichtemittierende Diode (OLED), zumindest ein transparentes Substrat, eine transparente Elektrode, eine organische lichtemittierende Schicht und darüber als weitere Elektrode eine strukturierte Rückseitenelektrode aufweisend, wobei die als strukturierte Rückseitenelektrode ausgeführte weitere Elektrode zumindest zwei Schichten hat, eine erste strukturierte Schicht, die die Injektionsschicht für die Elektronen ist, und eine zweite leitfähige Schicht, in die die erste Schicht eingebettet ist. Dabei kann die Herstellung der OLED die Schritte umfassen, dass auf einem transparenten Substrat mit einer transparenten Elektrode und zumindest einer organischen lichtemittierenden Schicht als weitere Elektrode eine Rückseitenelektrode mit zwei Schichten aufgebaut wird, wobei die erste Schicht strukturiert aufgebracht wird und in eine leitfähige zweite Schicht eingebettet wird. Die Rückseitenelektrode ("back electrode", auch Backelektrode genannt), kann dabei die Elektrode bezeichnen, die auf einer dem Substrat abgewandten Seite der organischen lichtemittierenden Schicht angeordnet ist.

Die vorab beschriebene Rückseitenelektrode, insbesondere deren zweite Schicht, kann dabei reflektierend für das in der organischen lichtemittierenden Schicht erzeugte Licht sein.

Weiterhin kann auch die weitere Elektrode transparent ausgeführt sein.

Die transparente Elektrode weist, wie oben beschrieben, zusätzlich zur weiteren Elektrode zumindest zwei Schichten auf, von denen eine strukturierte erste Schicht in eine zweite Schicht eingebettet ist.

Nach einer vorteilhaften Ausführungsform hat die strukturierte erste Schicht eine Dicke von kleiner oder gleich 12 nm, insbesondere von kleiner oder gleich 7 nm und besonders bevorzugt von kleiner oder gleich 5 nm.

Nach einer vorteilhaften Ausführungsform ist das Material der strukturierten ersten Schicht ausgewählt aus der Gruppe folgender Materialien: Barium (Ba), Calcium (Ca), Mg, Lithiumfluorid (LiF) und/oder Cäsiumfluorid (CsF), Cäsiumcarbonat sowie andere Carbonate und Fluoride beliebiger Mischungen dieser Materialien. Solche Materialien können besonders als Elektroneninjektoren dienen. Ebenso gut kann die erste strukturierte Schicht auch aus einem organischen Material sein. Weiterhin kann die strukturierte erste Schicht aus einem Löcher-injizierenden Material sein, beispielsweise eines der oben genannten transparenten leitfähigen Oxide.

Weiterhin kann die erste Schicht auch eine Dotierung in Form einer p⁺-, n⁺- oder p⁺+n⁺-Dotierung als Volumen- und/der Grenzflächendotierung aufweisen. Die erste Schicht kann dabei dotiert sein und wie oben beschrieben räumlich strukturiert sein.

Weiterhin kann die erste Schicht beispielsweise auch ein gleiches Material wie die zweite Schicht aufweisen, etwa ein TCO oder ein organisches Material, und die erste Schicht kann durch die Durchführung der Dotierung in diesem gleichen Material herstellbar sein. Dadurch kann das Material für die erste und zweite Schicht gleichzeitig und großflächig aufgebracht werden und danach kann durch das Dotieren die erste Schicht eingebettet in die zweite Schicht erzeugt werden.

Nach einer vorteilhaften Ausführungsform des Verfahrens wird die erste strukturierte Schicht der weiteren Elektrode unter Verwendung von Schattenmasken während des thermischen Aufdampfens strukturiert abgeschieden.

Nach anderen vorteilhaften Ausführungsformen des Verfahrens wird die erste Schicht durch andere beliebig wählbare strukturierende Aufbringungsmethoden erzeugt. Je nach Material können auch Präge- oder Druckverfahren eingesetzt werden.

Die zweite Schicht kann unstrukturiert aufgetragen werden, weil in sie die erste strukturierte Schicht eingebettet wird. Diese zweite Schicht kann auch zur Kontaktierung der ersten Schicht und zu deren Schutz vor korrosivem Angriff dienen.

Nach einer vorteilhaften Ausführungsform des Verfahrens wird im Falle der Rückseitenelektrode mit der ersten und zweiten Schicht die zweite Schicht auf die erste strukturierte Schicht in Form einer dickeren Schicht aus leitfähigem Material durch einfache Beschichtungsverfahren aufgebracht. Im Falle der substratseitigen Elektrode wird die zweite Schicht vor der ersten Schicht auf das Substrat aufgebracht und die erste Schicht in die zweite Schicht eingebettet.

Nach einer vorteilhaften Ausführungsform liegt die Dicke der zweiten Schicht im Bereich von 50 bis 300 nm, insbesondere im Bereich von 70 bis 250 nm und insbesondere bevorzugt im Bereich von 100 bis 200 nm.

Die Materialien und die Anordnung der transparenten Elektrode und der weiteren Elektrode kann dabei gemäß den obigen Ausführungen so gewählt sein, dass eine Strukturierung einer Elektrode aus einem TCO, beispielsweise einer ITO-Anode, nicht erforderlich ist.

In einer weiteren Ausführungsform kann die organische lichtemittierende Schicht eine strukturierte Ladungsträgersperrschicht aufweisen, die eine Elektronensperrschicht, eine Lochsperrschicht oder eine Sperrschicht für Elektronen und Löcher sein kann. Die transparente Elektrode ist dabei in einer der oben genannten Ausführungen strukturiert und die Ladungsträgersperrschicht kann in der organischen lichtemittierenden Schicht in den Bereichen angeordnet sein, in denen die strukturierte erste Schicht nicht vorhanden ist.

Die Ladungsträgersperrschicht kann beispielsweise an einer Grenzfläche zwischen der organischen lichtemittierenden Schicht und einer der Elektroden angeordnet sein und mittels einer weiteren organischen Schicht in die organische lichtemittierende Schicht eingebettet sein. Weiterhin kann die strukturierte Ladungsträgersperrschicht von organischen Schichten umschlossen sein, dass sich die Ladungsträgersperrschicht im Inneren der organischen lichtemittierenden Schicht befindet.

Dabei kann die strukturierte Ladungsträgersperrschicht eine Lochsperrschicht sein, die zwischen einer als Anode ausgebildeten Elektrode und einem aktiven, Licht erzeugenden Bereich der organischen lichtemittierenden Schicht angeordnet ist. Durch die strukturierte Ladungsträgersperrschicht kann dann verhindert werden, dass Löcher, die von der Anode in die organische lichtemittierende Schicht injiziert werden, bis zum aktiven, Licht erzeugenden Bereich gelangen können.

Alternativ oder zusätzlich kann die strukturierte Ladungsträgersperrschicht eine Elektronensperrschicht sein, die zwischen einer als Kathode ausgebildeten Elektrode und einem aktiven, Licht erzeugenden Bereich der organischen lichtemittierenden Schicht angeordnet ist.

Mittels der strukturierten Ladungsträgersperrschicht kann es auch möglich sein, in einer mehrfarbig abstrahlenden organischen lichtemittierenden Schicht einzelne Farben selektiv "auszuschalten". Das kann beispielsweise dann möglich sein, wenn die organische lichtemittierende Schicht mehrere großflächig übereinander angeordnete verschiedenfarbig abstrahlende aktive Bereiche aufweist, also einen Stapel von großflächig aufgebrachten organischen Schichten, die übereinander angeordnete aktive Bereiche aufweisen. Die Rekombination von Löchern und Elektronen in den übereinander angeordneten aktiven Bereichen kann durch die strukturierte Ladungsträgersperrschicht gezielt in bestimmten aktiven Bereichen teilweise verhindert werden. Dadurch kann ein mehrfarbig strukturierter Leuchteindruck bei einem Betrachter erweckt werden, obwohl die organische lichtemittierende Schicht und die übereinander angeordneten aktiven Bereiche insgesamt großflächig und kontinuierlich aufgebracht sind.

Die erfindungsgemäß strukturierten OLED-Anzeigenelemente wurden nach dem beschriebenen Maskenprozess erstellt und funktionieren bestens.

Weitere Vorteile und vorteilhafte Ausführungsformen und Weiterbildungen ergeben sich aus den im Folgenden in Verbindung mit den Figuren 1 bis 4 beschriebenen Ausführungsformen.

Es zeigen:
Figuren 1 bis 3B schematische Darstellungen organischer lichtemittierender Dioden gemäß einigen Beispielen und Ausführungsbeispielen und
Figur 4 ein Verfahren zur Herstellung einer organischen lichtemittierenden Diode gemäß einem weiteren Ausführungsbeispiel.

In den Beispielen, Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

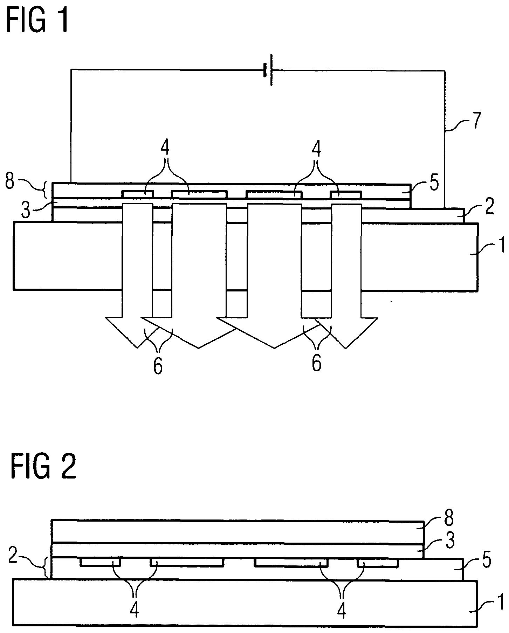

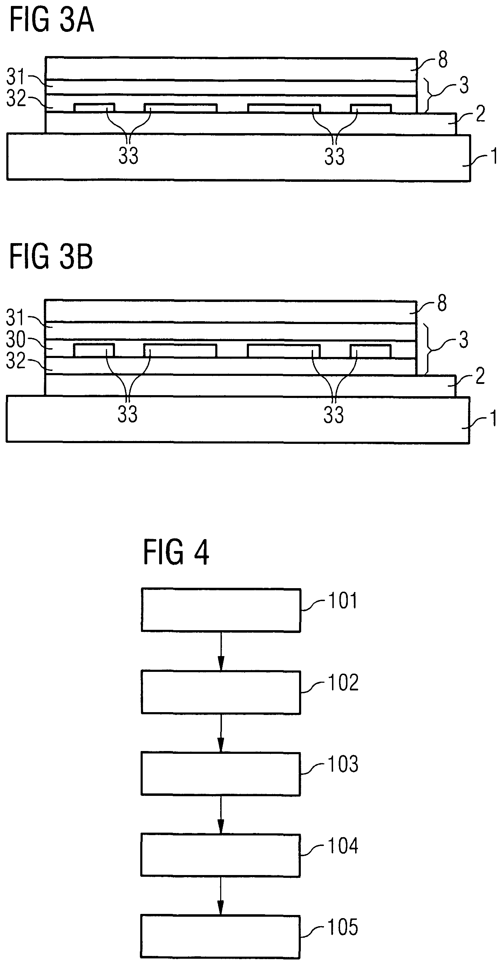

In Figur 1 ist ein nicht erfindungsgemäßes Beispiel für eine als Bottom-Emitter ausgeführte organische lichtemittierende Diode (OLED) gezeigt, die nach einem Verfahren gemäß der Figur 4 hergestellt werden kann. Die im Folgenden beschriebenen und mit den Bezugszeichen 101 bis 105 bezeichneten Verfahrensschritte beziehen sich auf Figur 4, während die strukturellen Merkmale der OLED in Figur 1 gezeigt sind.

Die in der Figur 1 gezeigten Schichten sind von unten nach oben die folgenden:
Unten liegt das transparente Substrat 1, das beispielsweise aus Glas, Quarz oder einer flexiblen Folie sein kann und das in einem ersten Verfahrenschritt 101 bereitgestellt wird. Das Substrat 1 kann alternativ zu dem gezeigten auch mehrschichtig aufgebaut sein.

Auf dem Substrat 1 liegt die unstrukturierte transparente Elektrode oder Anode 2, die beispielsweise aus ITO (Indium Zinn Oxide) sein kann. Die transparente Elektrode 2 wird dabei großflächig in einem Verfahrensschritt 102 auf einer Hauptoberfläche des Substrats aufgebracht.

Auf der transparenten und nach dem gezeigten Beispiel unstrukturierten Elektrode 2 wird die zumindest eine funktionelle organische lichtemittierende Schicht 3 in einem weiteren Verfahrensschritt 103 aufgebracht. Die organische lichtemittierende Schicht 3 kann auch aus mehreren Schichten aufgebaut sein und wird entlang der Erstreckungsebene der Hauptoberfläche des Substrats 1 großflächig und kontinuierlich angeordnet. Die funktionelle organische lichtemittierende Schicht 3 emittiert Licht, das in Richtung der Pfeile 6 von der OLED abgestrahlt werden kann.

Auf den funktionellen organischen lichtemittierenden Schichten 3 oder der funktionellen organischen lichtemittierenden Schicht 3 wird in einem weiteren Verfahrensschritt 104 die erste strukturierte Schicht 4 der als Rückseitenelektrode ausgeführten weiteren Elektrode 8 aufgebracht. Die Strukturierung der strukturierten ersten Schicht 4 kann während des Aufdampfens einer der Materialien wie Ba, Mg, Ca, LiF, CsF, CS₂CO₃ durch einfache Schattenmasken erzeugt werden. Auf diese Schicht wird in einem weiteren Verfahrensschritt 105 die zweite leitfähige Schicht 5 der Rückseitenelektrode 8 in Form einer Deckschicht aus leitfähigem Material aufgebracht, beispielsweise durch einfache Beschichtungsmethoden wie Spincoating, Rakeln, Sprühen, Siebdruck etc. Die als Deckschicht ausgeführte zweite Schicht 5 bettet die erste Schicht 4 der Rückseitenelektrode ein, so dass die erste Schicht 4 der Rückseitenelektrode 8 vor Korrosion geschützt ist.

Die Leitung 7 zeigt die Kontaktierung zwischen der unteren transparenten Elektrode 2 und der als Rückseitenelektrode ausgeführten weiteren Elektrode 8, die zumindest die beiden Schichten 4 und 5 hat. Das Bauteil hat vorteilhafterweise eine Verkapselung, die der Einfachheit halber in Figur 1 nicht gezeigt ist.

Aus der ersten Schicht 4 können leicht Elektronen in die organische lichtemittierende Schicht 3 injiziert werden, die mit Löchern, die aus der transparenten Elektrode 2 in die organische lichtemittierende Schicht 3 injiziert werden, unter Abstrahlung von Licht rekombinieren können. Dabei wird das Licht bevorzugt in den Bereichen unterhalb der ersten Schicht 4 abgestrahlt, so dass die OLED ein leuchtendes Bild abstrahlen kann, das der Strukturierung der ersten strukturierten Schicht 4 entspricht.

Der Vorteil des vorgeschlagenen Strukturierungsverfahrens gegenüber dem beschriebenen Standardprozess ist, dass keine Photolithographie notwendig ist. Dadurch ergeben sich Einsparungen hinsichtlich Kosten und Zeit. Im Unterschied zu den in der Photolithographie verwendeten Spezialmasken, sind die im Aufdampfverfahren eingesetzten Schattenmasken preisgünstig und einfach in der Herstellung. Insbesondere die Darstellung einfacher Strukturen, Formen und Symbole aber auch Schriftzüge lassen sich ohne größeren zeitlichen und kostenbezogenen Aufwand anhand von Schattenmasken realisieren. Dadurch ergeben sich besondere Wettbewerbschancen für OLEDs als Anwendung für leuchtende starre Anzeigen zur Beschilderung und Kennzeichnung.

Gemäß diesem Beispiel werden eine OLED mit strukturierter Rückseitenelektrode und ein Herstellungsverfahren für eine OLED mit strukturierter Rückseitenelektrode beschrieben, wobei die Rückseitenelektrode zumindest zwei Schichten umfasst, eine erste strukturierte, Elektronen-injizierende und dünne Schicht, die in die zweite leitfähige und dickere Schicht eingebettet ist. Eine Strukturierung der Anode kann dabei in der Regel überflüssig sein.

Alternativ kann die transparente Elektrode 2 auch als Kathode und die weitere Elektrode 8 als Anode ausgeführt sein. Die weitere Elektrode 8 kann zusätzlich oder alternativ zur Elektrode 2 transparent ausgeführt sein, so dass die OLED zusätzlich oder alternativ auch als Top-Emitter ausgebildet sein kann.

In Figur 2 ist ein erfindungsgemäßes Ausführungsbeispiel für eine OLED gezeigt. Im Folgenden werden dabei insbesondere die Unterschiede zum vorherigen Beispiel beschrieben.

Die in Figur 2 gezeigte OLED weist auf dem Substrat 1 eine transparente Elektrode 2 mit einer zweiten Schicht 5 auf, in die eine erste Schicht 4 eingebettet ist. Dazu kann beispielsweise die zweite Schicht 5 auf dem Substrat aufgebracht werden und die erste Schicht 4 durch strukturierte Dotierung in der zweiten Schicht 5 erzeugt werden. Die Dotierung kann eine verbesserte Injektion von Ladungsträgern in die organische lichtemittierende Schicht 3 bewirken oder eine Injektion von Ladungsträgern in die organische lichtemittierende Schicht 3 erst ermöglichen. Über der organischen lichtemittierenden Schicht 3 ist eine großflächige weitere Elektrode 8 aufgebracht.

Weiterhin ist auch eine OLED möglich, die eine Kombination der Rückseitenelektrode 8 aus Figur 1 und der transparenten Elektrode 2 aus Figur 2 aufweist.

In Figur 3A ist ein weiteres nicht erfindungsgemäßes Beispiel für eine OLED gezeigt, die zwei großflächig aufgebrachte Elektroden, nämlich eine transparente Elektrode 2, die als Anode ausgebildet ist, und eine weitere Elektrode 8, die als Kathode ausgebildet ist, aufweist. Zwischen den Elektroden ist eine organische lichtemittierende Schicht 3 angeordnet, die einen Schichtenstapel mit großflächigen organischen Schichten 31 und 32 und einer strukturierten Ladungsträgersperrschicht 33 aufweist. Die organische Schicht 32 ist im gezeigten Ausführungsbeispiel eine Lochtransportschicht, die über der strukturierten Lochsperrschicht 33 aufgebracht ist. Dadurch werden nur in den Bereichen Löcher in die organische lichtemittierende Schicht 3 injiziert, wo die Lochtransportschicht 32 an die transparente Elektrode 2 grenzt.

Die organische Schicht 31 ist als Elektronentransportschicht ausgeführt, so dass Elektronen und Löcher an der Grenzfläche zwischen den organischen Schichten 31 und 32 und Abstrahlung von Licht rekombinieren können. Alternativ oder zusätzlich zum gezeigten Ausführungsbeispiel kann die strukturierte Lochsperrschicht 33 auch bis zur Grenzfläche zwischen den Schichten 31 und 32 oder sogar in die Elektronentransportschicht 31 hineinragen. Weiterhin kann auch anstelle der gezeigten Lochsperrschicht 33 eine Elektronensperrschicht in die Elektronentransportschicht 31 eingebettet sein.

In Figur 3B ist ein weiteres nicht erfindungsgemäßes Beispiel für eine OLED gezeigt, die im Gegensatz zur OLED aus dem Beispiel gemäß Figur 3A eine organische lichtemittierende Schicht 3 aufweist, die Elektronentransportschicht 31 und eine Lochtransportschicht 32 aufweist, zwischen denen eine Elektrolumineszenzschicht 30 angeordnet ist. In der Elektrolumineszenzschicht 30 können Elektronen und Löcher, die über die Elektroden 2 und 8 in die organische lichtemittierende Schicht 3 injiziert werden, unter Aussendung von Licht rekombinieren. Eine strukturierte Ladungsträgersperrschicht 33, die als Elektronen- und als Lochsperrschicht ausgeführt ist, ist in die Elektrolumineszenschicht 30 eingebettet, so dass die Rekombination nur in den Bereichen der Elektrolumineszenzschicht 30 stattfinden kann, in denen keine Ladungsträgersperrschicht 33 vorhanden ist, wodurch eine strukturierte Abstrahlung bzw. ein strukturierter Leuchteindruck der OLED erreicht werden kann.

## Patentansprüche

1. Organische lichtemittierende Diode (OLED), umfassend
- ein transparentes Substrat (1) und
- auf dem Substrat (1) eine organische lichtemittierende Schicht (3), die zwischen einer transparenten Elektrode (2) und einer weiteren Elektrode (8) angeordnet ist, wobei
- die transparente Elektrode (2) zwei Schichten (4, 5) aufweist und die zwei Schichten (4, 5) eine strukturierte erste Schicht (4), die eine Ladungsträgerinjektionsschicht ist, und eine leitfähige zweite Schicht (5) umfassen,
- die transparente Elektrode (2) auf der dem Substrat (1) zugewandten Seite der organischen Licht emittierenden Schicht (3) angeordnet ist und
- die strukturierte erste Schicht (4) zwischen der organischen lichtemittierenden Schicht (3) und der leitfähigen zweiten Schicht (5) angeordnet ist und die zweite Schicht im Vergleich zur ersten Schicht eine geringere oder gar keine Ladungsträgerinjektion in die organische lichtemittierende Schicht aufweist,
**dadurch gekennzeichnet, dass**
- die strukturierte erste Schicht in die leitfähige zweite Schicht eingebettet ist.

2. OLED nach Anspruch 1, wobei
- die transparente Elektrode (2) als Anode und die weitere Elektrode (8) als Kathode ausgebildet ist.

3. OLED nach Anspruch 2, wobei
- die weitere Elektrode (8) als Rückseitenelektrode ausgebildet ist und die Rückseitenelektrode strukturiert ist und zumindest zwei Schichten (4, 5) aufweist, wobei die zwei Schichten eine weitere erste strukturierte Schicht (4), die eine Injektionsschicht für Elektronen ist, und eine weitere leitfähige zweite Schicht (5) aufweist, in der die weitere erste strukturierte Schicht (4) eingebettet ist.

4. OLED nach Anspruch 1, wobei
- die transparente Elektrode (2) als Kathode und die weitere Elektrode (8) als Anode ausgebildet ist.

5. OLED nach Anspruch 4, wobei
- das Material der strukturierten ersten Schicht (4) ausgewählt ist aus der Gruppe folgender Materialien: Barium (Ba), Magnesium (Mg), Calcium (Ca), Lithiumfluorid (LiF) Cäsiumcarbonat und/oder Cäsiumfluorid (CsF), sowie andere Carbonate oder Fluoride und beliebige Mischungen dieser Materialien.

6. OLED nach einem der vorherigen Ansprüche, wobei
- die strukturierte erste Schicht (4) eine Dicke von kleiner oder gleich 12 nm hat.

7. OLED nach einem der vorherigen Ansprüche, wobei
- die leitfähige zweite Schicht (5) eine Schicht aus leitfähigem Material ist, die eine größere Dicke als die strukturierte erste Schicht aufweist und die durch einfache Beschichtungs- und/oder Druckverfahren aufbringbar ist.

8. OLED nach einem der Ansprüche 1 bis 7, wobei
- die leitfähige zweite Schicht (5) eine Dicke im Bereich von 50 bis 300 nm hat.

9. OLED nach einem der vorherigen Ansprüche, wobei
- die organische lichtemittierende Schicht (3) eine strukturierte Ladungsträgersperrschicht (33) umfasst.

10. OLED nach einem der vorherigen Ansprüche, wobei
- die organische lichtemittierende Schicht (3) einen Schichtstapel mit zumindest einer der folgenden Schichten umfasst: eine Lochinjektionsschicht, eine Lochtransportschicht, eine Elektronensperrschicht, eine Elektrolumineszenzschicht, eine Lochsperrschicht, eine Elektronentransportschicht und eine Elektroneninjektionsschicht.

11. OLED nach einem der vorherigen Ansprüche, wobei
- die organische lichtemittierende Schicht (3), die transparente Elektrode (2) und die weitere Elektrode (8) großflächig auf dem Substrat aufgetragen sind.

12. OLED nach einem der vorherigen Ansprüche, wobei
- im Betrieb der OLED für einen Betrachter ein strukturierter Leuchteindruck entsteht.

13. Verfahren zur Herstellung einer organischen lichtemittierenden Diode (OLED), bei dem
- auf einem transparenten Substrat (1) eine organische lichtemittierende Schicht (3) aufgebracht wird und die organische lichtemittierende Schicht (3) zwischen einer transparenten Elektrode (2) und einer großflächigen weiteren Elektrode (8) angeordnet wird,
wobei
- die transparente Elektrode (2) derart aufgebracht wird, dass eine strukturierte erste Schicht (4), die eine Ladungsträgerinjektionsschicht ist, in eine leitfähige zweite Schicht (5) eingebettet wird,
- die transparente Elektrode (2) auf der dem Substrat (1) zugewandten Seite der organischen Licht emittierenden Schicht (3) angeordnet ist und die strukturierte erste Schicht (4) zwischen der organischen lichtemittierenden Schicht (3) und der leitfähigen zweiten Schicht (5) angeordnet ist und die zweite Schicht im Vergleich zur ersten Schicht eine geringere oder gar keine Ladungsträgerinjektion in die organische lichtemittierende Schicht aufweist.

14. Verfahren zur Herstellung einer OLED nach Anspruch 13, bei dem
- auf dem Substrat (1) mit der transparenten Elektrode (2) und zumindest einer organischen aktiven Schicht (3) als weitere Elektrode (8) eine Rückseitenelektrode mit zwei weiteren Schichten (4, 5) aufgebaut wird, wobei die erste weitere Schicht (4) der weiteren Elektrode (8) strukturiert aufgebracht wird und in eine leitfähige zweite weitere Schicht (5) der weiteren Elektrode (8) eingebettet wird.

15. Verfahren nach Anspruch 14, bei dem
- die weitere erste Schicht (4) strukturiert durch Aufdampfen durch eine Schattenmaske aufgebracht wird.

16. Verfahren nach einem der Ansprüche 14 oder 15, bei dem
- beim Aufbringen der organischen lichtemittierenden Schicht (3) eine strukturierte Ladungsträgersperrschicht (33) aufgebracht wird.

## Claims

1. Organic light-emitting diode (OLED) comprising
- a transparent substrate (1) and
- on the substrate (1) an organic light-emitting layer (3) arranged between a transparent electrode (2) and a further electrode (8),
wherein
- the transparent electrode (2) has two layers (4, 5) and the two layers (4, 5) comprise a structured first layer (4), which is a charge carrier injection layer, and a conductive second layer (5), in which the first layer (4) is embedded, **characterised in that**
- the transparent electrode (2) is arranged on the side of the organic light-emitting layer (3) facing the substrate (1) and
- the structured first layer (4) is arranged between the organic light-emitting layer (3) and the conductive second layer (5) and the second layer has a lower or no charge carrier injection into the organic light-emitting layer compared to the first layer.

2. OLED according to claim 1, wherein
- the transparent electrode (2) is formed as an anode and the further electrode (8) as a cathode.

3. OLED according to claim 2, wherein
- the further electrode (8) is formed as a backside electrode and the backside electrode is structured and has at least two layers (4, 5), wherein the two layers comprise a further first structured layer (4), which is an injection layer for electrons, and a further conductive second layer (5), in which the first structured layer (4) is embedded.

4. OLED according to claim 1, wherein
- the transparent electrode (2) is formed as a cathode and the further electrode (8) as an anode.

5. OLED according to claim 4, wherein
- the material of the structured first layer (4) is selected from the group of the following materials: barium (Ba), magnesium (Mg), calcium (Ca), lithium fluoride (LiF) caesium carbonate and/or caesium fluoride (CsF), as well as other carbonates or fluorides and any mixtures of these materials.

6. OLED according to one of the preceding claims, wherein
- the structured first layer (4) has a thickness of less than or equal to 12 nm.

7. OLED according to one of the preceding claims, wherein
- the conductive second layer (5) is a layer of conductive material having a greater thickness than the structured first layer.

8. OLED according to one of claims 1 to 7, wherein
- the conductive second layer (5) has a thickness in the range from 50 to 300 nm.

9. OLED according to one of the preceding claims, wherein
- the organic light-emitting layer (3) comprises a structured charge carrier barrier layer (33).

10. OLED according to one of the preceding claims, wherein
- the organic light emitting layer (3) comprises a layer stack having at least one of the following layers: a hole injection layer, a hole transport layer, an electron barrier layer, an electroluminescence layer, a hole barrier layer, an electron transport layer and an electron injection layer.

11. OLED according to one of the preceding claims, wherein
- the organic light-emitting layer (3), the transparent electrode (2) and the further electrode (8) are applied to the substrate over a large area.

12. OLED according to one of the preceding claims, wherein
- a structured luminous effect is produced for a viewer during operation of the OLED.

13. Method for producing an organic light-emitting diode (OLED), in which
- an organic light-emitting layer (3) is applied to a transparent substrate (1) and the organic light-emitting layer (3) is arranged between a transparent electrode (2) and a large-area further electrode (8),
wherein
- the transparent electrode (2) is applied such that a structured first layer (4), which is a charge carrier injection layer, is embedded in a conductive second layer (5),
**characterised in that** the transparent electrode (2) is arranged on the side of the organic light-emitting layer (3) facing the substrate (1) and the structured first layer (4) is arranged between the organic light-emitting layer (3) and the conductive second layer (5) and the second layer has a lower or no charge carrier injection into the organic light-emitting layer compared to the first layer.

14. Method for producing an OLED according to claim 13, in which
- on the substrate (1) with the transparent electrode (2) and at least one organic active layer (3) as further electrode (8), a backside electrode with two further layers (4, 5) is constructed, wherein the first further layer (4) of the further electrode (8) is applied in a structured manner and is embedded in a conductive second further layer (5) of the further electrode (8).

15. Method according to claim 14, in which
- the further first layer (4) is applied in a structured manner by vapour deposition through a shadow mask.

16. Method according to one of the claims 14 or 15, in which
- a structured charge carrier barrier layer (33) is applied during the application of the organic light-emitting layer (3).

## Revendications

1. Diode électroluminescente organique (OLED) comprenant
- un substrat transparent (1) et
- sur le substrat (1), une couche organique émettrice de lumière (3) disposée entre une électrode transparente (2) et une autre électrode (8),
Dans laquelle
- l'électrode transparente (2) comporte deux couches (4, 5) et les deux couches (4, 5) comprennent une première couche structurée (4), qui est une couche d'injection de porteurs de charge, et une deuxième couche conductrice (5), dans laquelle la première couche (4) est incorporée,
**caractérisé en ce que**
- l'électrode transparente (2) est disposée sur le côté de la couche organique émettrice de lumière (3) qui fait face au substrat (1) et
- la première couche structurée (4) est disposée entre la couche organique émettrice de lumière (3) et la deuxième couche conductrice (5), et la deuxième couche présente une injection de porteurs de charge inférieure ou nulle dans la couche organique émettrice de lumière par rapport à la première couche.

2. OLED selon la revendication 1, dans laquelle
- l'électrode transparente (2) est conçue comme l'anode et l'autre électrode (8) comme la cathode.

3. OLED selon la revendication 2, dans laquelle
- l'autre électrode (8) est formée comme une électrode arrière et l'électrode arrière est structurée et comporte au moins deux couches (4, 5), les deux couches comprenant une première couche structurée supplémentaire (4), qui est une couche d'injection pour les électrons, et une deuxième couche conductrice supplémentaire (5) dans laquelle la première couche structurée (4) est incorporée.

4. OLED selon la revendication 1, dans laquelle
- l'électrode transparente (2) est formée comme une cathode et l'autre électrode (8) comme une anode.

5. OLED selon la revendication 4, dans laquelle
- le matériau de la première couche structurée (4) est choisi dans le groupe des matériaux suivants: baryum (Ba), magnésium (Mg), calcium (Ca), fluorure de lithium (LiF) carbonate de césium et/ou fluorure de césium (CsF), ainsi que d'autres carbonates ou fluorures et tout mélange de ces matériaux.

6. OLED selon l'une des revendications précédentes, dans laquelle
- la première couche structurée (4) a une épaisseur inférieure ou égale à 12 nm.

7. OLED selon l'une des revendications précédentes, dans laquelle
- la deuxième couche conductrice (5) est une couche de matériau conducteur ayant une épaisseur plus importante que la première couche structurée.

8. OLED selon l'une des revendications 1 à 7, dans laquelle
- la deuxième couche conductrice (5) a une épaisseur comprise entre 50 et 300 nm.

9. OLED selon l'une des revendications précédentes, dans laquelle
- la couche organique émettrice de lumière (3) comprend une couche barrière structurée de porteurs de charge (33).

10. OLED selon l'une des revendications précédentes, dans laquelle
- la couche organique émettrice de lumière (3) comprend un empilement de couches ayant au moins une des couches suivantes: une couche d'injection de trous, une couche de transport de trous, une couche de barrière d'électrons, une couche d'électroluminescence, une couche de barrière de trous, une couche de transport d'électrons et une couche d'injection d'électrons.

11. OLED selon l'une des revendications précédentes, dans laquelle
- la couche organique émettrice de lumière (3), l'électrode transparente (2) et l'autre électrode (8) sont appliquées sur le substrat sur une grande surface.

12. OLED selon l'une des revendications précédentes, dans laquelle
- und effet lumineux structuré est produit pour un observateur pendant le fonctionnement de l'OLED.

13. Procédé de fabrication d'une diode électroluminescente organique (OLED), dans lequel
- une couche organique émettrice de lumière (3) est appliquée sur un substrat transparent (1) et la couche organique émettrice de lumière (3) est disposée entre une électrode transparente (2) et une autre électrode de grande surface (8),
dans lequel
- l'électrode transparente (2) est appliquée de telle sorte qu'une première couche structurée (4), qui est une couche d'injection de porteurs de charge, est incorporée dans une deuxième couche conductrice (5),
**caractérisé en ce que** l'électrode transparente (2) est disposée sur la face de la couche organique d'émission de lumière (3) tournée vers le substrat (1) et la première couche structurée (4) est disposée entre la couche organique d'émission de lumière (3) et la deuxième couche conductrice (5) et la deuxième couche présente une injection de porteurs de charge inférieure ou nulle dans la couche organique d'émission de lumière par rapport à la première couche.

14. Procédé de fabrication d'une OLED selon la revendication 13, dans lequel
- sur le substrat (1) avec l'électrode transparente (2) et au moins une couche active organique (3) comme autre électrode (8), on construit une électrode arrière avec deux autres couches (4, 5), dans lequel la première autre couche (4) de l'autre électrode (8) étant appliquée de manière structurée et étant noyée dans une deuxième autre couche (5) conductrice de l'autre électrode (8).

15. Procédé selon la revendication 14, dans lequel
- la première couche supplémentaire (4) est appliquée de manière structurée par dépôt de vapeur à travers un masque d'ombre.

16. Procédé selon l'une des revendications 14 ou 15, dans lequel
- une couche barrière de porteurs de charge structurée (33) est appliquée pendant l'application de la couche organique émettrice de lumière (3).
